# FASCICULE DE BREVET EUROPEEN

(11) **EP 3 014 665 B1**
(45) Date de publication et mention de la délivrance du brevet: **04.03.2020**
(21) Numéro de dépôt: 14742275.2
(22) Date de dépôt: 25.06.2014
(51) Int. Cl.: H01L 33/18, H01L 33/24, H01L 33/40, H01L 33/08, H01L 33/46, H01L 33/32

(54) **DISPOSITIF OPTOÉLECTRONIQUE À RÉFLECTIVITÉ AMÉLIORÉE ET SON PROCÉDÉ DE FABRICATION**
OPTOELEKTRONISCHE VORRICHTUNG MIT VERBESSERTER REFLEXION UND VERFAHREN ZU IHRER HERSTELLUNG
OPTOELECTRONIC DEVICE WITH IMPROVED REFLECTIVITY AND METHOD OF MANUFACTURING THE SAME

(30) Priorité: 25.06.2013 FR 1356059
(43) Date de publication de la demande: 04.05.2016
(73) Titulaire: Commissariat à l'Énergie Atomique et aux Énergies Alternatives, 75015 Paris (FR); Aledia, 38040 Grenoble (FR)
(72) Inventeur: HYOT, Bérangère, F-38320 Eybens (FR); GILET, Philippe, F-38470 Teche (FR)
(74) Mandataire: Cabinet Beaumont
(86) Numéro de dépôt international: PCT/FR2014/051591
(87) Numéro de publication internationale: WO 2014/207378

(56) Documents cités:
- DE-A1-102011 056 140
- US-A1- 2008 149 944
- US-A1- 2010 127 238
- US-B1- 8 350 251
- E F Schubert: "Refractive index and extinction coefficient of materials", , 1 janvier 2004 (2004-01-01), pages 1-276, XP055113489, Extrait de l'Internet: URL:http://homepages.rpi.edu/~schubert/Edu cational-resources/Materials-Refractive-in dex-and-extinction-coefficient.pdf [extrait le 2014-04-10]
- Ian R Hooper ET AL: "Some considerations on the transmissivity of thin metal films", OPTICS EXPRESS, Vol. 16, No. 22, 13 octobre 2008 (2008-10-13), pages 17249-17257, XP055113795, Extrait de l'Internet: URL:https://newton.ex.ac.uk/research/emag/ pubs/pdf/Hooper_OE_2008.pdf [extrait le 2014-04-11]
- "Mirrors, Coating Choice Makes a Difference", , 11 février 2013 (2013-02-11), pages 1-3, XP055144933, EDU.photonics.com Extrait de l'Internet: URL:https://web.archive.org/web/2013021100 0824/http://www.photonics.com/edu/Handbook .aspx?AID=25501 [extrait le 2014-10-07]

## Description

Le présent brevet revendique la priorité de la demande de brevet français FR13/56059.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Les éléments tridimensionnels, notamment des microfils ou nanofils semiconducteurs, sont généralement formés sur un substrat et chaque élément tridimensionnel est au moins partiellement recouvert d'une structure semiconductrice adaptée à émettre de la lumière. Un observateur voit la lumière émise par les diodes électroluminescentes qui s'échappe du dispositif optoélectronique. Toutefois, une partie de la lumière émise par les diodes électroluminescentes est capturée par les éléments tridimensionnels ou par le substrat et n'est donc pas vue par un observateur. Il serait souhaitable d'augmenter la portion de la lumière émise par les diodes électroluminescentes qui parvient à s'échapper du dispositif optoélectronique. Dans ce contexte, des dispositifs optoélectroniques à base de nanofils semiconducteurs à structure coaxiale coeur-coquille de diode électroluminescente sont connus de, par exemple, US 8 350 251 B1.

### Résumé

La présente invention prévoit un dispositif optoélectronique selon la revendication 1. Le dispositif optoélectronique selon l'invention comprend:
- un substrat ;
- une première couche ou des premières portions recouvrant le substrat, la première couche ou les premières portions ayant une épaisseur supérieure ou égale à 15 nm et comprenant un premier matériau ayant un coefficient d'extinction supérieur ou égal à 3 pour toute longueur d'onde comprise entre 380 nm et 650 nm ;
- une deuxième couche ou des deuxièmes portions recouvrant la première couche ou les premières portions et au contact de la première couche ou des premières portions, la deuxième couche ou les deuxièmes portions ayant une épaisseur inférieure ou égale à 20 nm et comprenant un deuxième matériau ayant un indice de réfraction compris entre 1 et 3 et un coefficient d'extinction inférieur ou égal à 1,5 pour toute longueur d'onde comprise entre 380 nm et 650 nm ; et
- des ensembles à structure de diodes électroluminescentes comprenant des éléments semiconducteurs filaires, coniques ou tronconiques, les éléments semiconducteurs étant au contact de la deuxième couche ou des deuxièmes portions, la première couche ou les premières portions étant interposée(s) entre le substrat et les éléments semiconducteurs,
   dispositif dans lequel le deuxième matériau est choisi parmi le groupe comprenant un nitrure, un carbure ou un borure d'un métal de transition de la colonne IV, V ou VI du tableau périodique des éléments ou une combinaison de ces composés, ou est spécifiquement choisi parmi le groupe comprenant le nitrure d'aluminium (AlN), le bore (B), le nitrure de bore (BN), le titane (Ti), le nitrure de titane (TiN), le tantale (Ta), le nitrure de tantale (TaN), l'hafnium (Hf), le nitrure d'hafnium (HfN), le niobium (Nb), le nitrure de niobium (NbN), le zirconium (Zr), le borate de zirconium (ZrB₂), le nitrure de zirconium (ZrN), le carbure de silicium (SiC), le nitrure et carbure de tantale (TaCN), le nitrure de magnésium sous la forme MgₓN_{y}, où x est environ égal à 3 et y est environ égal à 2, par exemple le nitrure de magnésium selon la forme Mg₃N₂ ou le nitrure de gallium et de magnésium (MgGaN), le tungstène (W), le nitrure de tungstène (WN) ou une combinaison de ces composés.

Selon un mode de réalisation, le premier matériau est choisi parmi le groupe comprenant le chrome, le rhodium, le ruthénium, le palladium ou un alliage de deux de ces composés ou de plus de deux de ces composés.

Selon un mode de réalisation, chaque élément semiconducteur comprend un microfil ou un nanofil.

Selon un mode de réalisation, le substrat est en un troisième matériau semiconducteur choisi parmi le groupe comprenant le silicium, le germanium, le carbure de silicium, un composé III-V, un composé II-VI et une combinaison de ces composés.

Selon un mode de réalisation, chaque élément semiconducteur comprend au moins une partie comprenant majoritairement un quatrième matériau semiconducteur en contact avec la deuxième couche ou l'une des deuxièmes portions, le quatrième matériau semiconducteur étant choisi parmi le groupe comprenant le silicium, le germanium, le carbure de silicium, un composé III-V, un composé II-VI et une combinaison de ces composés.

Selon un mode de réalisation, chaque élément semiconducteur est au moins partiellement recouvert d'une structure semiconductrice adaptée à émettre de la lumière.

Selon un mode de réalisation, le dispositif optoélectronique comprend, en outre, une troisième couche entre la première couche ou les premières portions et le substrat.

Selon un mode de réalisation, la troisième couche et la deuxième couche ou les deuxièmes portions sont du même matériau.

La présente invention prévoit, en outre, un procédé de fabrication d'un dispositif optoélectronique selon la revendication 9.

Le procédé selon l'invention de fabrication d'un dispositif optoélectronique comprend les étapes suivantes :
- former, sur un substrat, une première couche ou des premières portions, la première couche ou les premières portions ayant une épaisseur supérieure ou égale à 15 nm et comprenant un premier matériau ayant un coefficient d'extinction supérieur ou égal à 3 pour toute longueur d'onde comprise entre 380 nm et 650 nm ;
- former une deuxième couche ou des deuxièmes portions recouvrant la première couche ou les premières portions et au contact de la première couche ou des premières portions, la deuxième couche ou les deuxièmes portions ayant une épaisseur inférieure ou égale à 20 nm et comprenant un deuxième matériau ayant un indice de réfraction compris entre 1 et 3 et un coefficient d'extinction inférieur ou égal à 1,5 pour toute longueur d'onde comprise entre 380 nm et 650 nm ; et
- former des ensembles à structure de diodes électroluminescentes comprenant des éléments semiconducteurs filaires, coniques ou tronconiques au contact de la deuxième couche ou des deuxièmes portions, la première couche ou les premières portions étant interposées entre le substrat et les éléments semiconducteurs, procédé dans lequel le deuxième matériau est choisi parmi le groupe comprenant un nitrure, un carbure ou un borure d'un métal de transition de la colonne IV, V ou VI du tableau périodique des éléments ou une combinaison de ces composés, ou est spécifiquement choisi parmi le groupe comprenant le nitrure d'aluminium (AIN), le bore (B), le nitrure de bore (BN), le titane (Ti), le nitrure de titane (TiN), le tantale (Ta), le nitrure de tantale (TaN), l'hafnium (Hf), le nitrure d'hafnium (HfN), le niobium (Nb), le nitrure de niobium (NbN), le zirconium (Zr), le borate de zirconium (ZrB₂), le nitrure de zirconium (ZrN), le carbure de silicium (SiC), le nitrure et carbure de tantale (TaCN), le nitrure de magnésium sous la forme MgₓN_{y}, où x est environ égal à 3 et y est environ égal à 2, par exemple le nitrure de magnésium selon la forme Mg₃N₂ ou le nitrure de gallium et de magnésium (MgGaN), le tungstène (W), le nitrure de tungstène (WN) ou une combinaison de ces composés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un exemple, illustratif du contexte de l'invention mais n'en faisant pas partie, d'un dispositif optoélectronique à microfils ou nanofils ;
la figure 2 est une coupe, partielle et schématique, d'un mode de réalisation d'un dispositif optoélectronique à microfils ou nanofils à réflectivité améliorée selon la présente invention ;
la figure 3 représente des courbes d'évolution, en fonction de la longueur d'onde, de la réflectivité des dispositifs optoélectroniques des figures 1 et 2 sous chaque microfil ou nanofil ;
la figure 4 représente un domaine d'indices de réfraction et de coefficients d'extinction du dispositif optoélectronique de la figure 1 pour lequel la réflectivité est supérieure à 30 % ;
les figures 5A à 5E représentent des domaines d'indices de réfraction et de coefficients d'extinction pour plusieurs dispositifs optoélectroniques de la figure 2 pour lesquels la réflectivité est supérieure à 40 % ; et
les figures 6 et 7 représentent chacune des courbes d'évolution, en fonction de la longueur d'onde, de la réflectivité des dispositifs optoélectroniques des figures 1 et 2 entre deux microfils ou nanofils adjacents.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %. Dans la description et les revendications, l'expression "pour une longueur d'onde comprise" signifie "pour toute longueur d'onde comprise".

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Une couche de germination est formée sur une face d'un substrat. A titre de variante, des plots ou îlots, appelés également par la suite îlots de germination, sont formés sur une face d'un substrat. La couche de germination ou les îlots de germination sont en un matériau favorisant la croissance des fils. Dans le cas d'îlots de germination, un traitement est, en outre, prévu pour protéger les flancs latéraux des îlots de germination et la surface des parties du substrat non recouvertes par les îlots de germination pour empêcher la croissance des fils sur les flancs latéraux des îlots de germination et sur la surface des parties du substrat non recouvertes par les îlots de germination. Le traitement peut comprendre la formation d'une région diélectrique sur les flancs latéraux des îlots de germination et s'étendant sur et/ou dans le substrat et reliant, pour chaque paire d'îlots, l'un des îlots de la paire à l'autre îlot de la paire, les fils ne croissant pas sur la région diélectrique.

Le substrat peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, ou un substrat en ZnO. Le substrat peut être en un matériau conducteur, par exemple en métal, ou en un matériau isolant, par exemple en saphir, en verre ou en céramique.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant la couche de germination ou les îlots de germination est choisi de façon à favoriser la croissance des fils selon la même polarité. A titre d'exemple, lorsque les fils comprennent majoritairement un composé III-V, le matériau constituant les îlots de germination est choisi de préférence de façon à favoriser la croissance du composé III-V selon la polarité de l'élément du groupe V. Le composé III-V croît alors selon la polarité de l'élément du groupe V sur la couche de germination ou sur les îlots de germination. En outre, les inventeurs ont mis en évidence que chaque fil croît alors selon une polarité sensiblement constante dans la totalité du fil. Lorsque les fils comprennent majoritairement un composé II-VI, le matériau constituant la couche de germination ou les îlots de germination est choisi de préférence de façon à favoriser la croissance du composé II-VI selon la polarité de l'élément du groupe VI. Le composé II-VI croît alors selon la polarité de l'élément du groupe VI sur la couche de germination ou les îlots de germination. Dans le cas d'un composé III-V dans lequel l'élément du groupe V est l'azote, le matériau composant la couche de germination ou les îlots de germination peut être un matériau favorisant la croissance d'un fil selon la polarité N.

Le procédé de croissance des fils peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

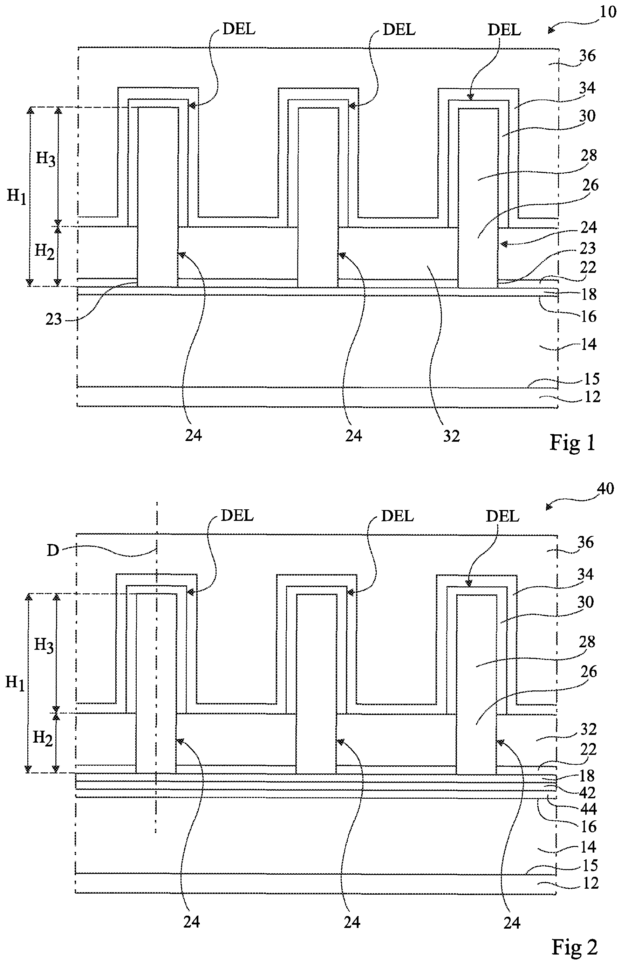

La figure 1 est une coupe, partielle et schématique, d'un exemple, illustratif du contexte de la présente invention mais n'en faisant pas partie, d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat semiconducteur 14 comprenant des faces opposées 15 et 16, la face 15 étant au contact de l'électrode 12 ;
une couche de germination 18 favorisant la croissance de fils et disposée sur la face 16 ;
une couche isolante 22 s'étendant sur la couche de germination 18 et comprenant des ouvertures 23 qui exposent chacune une partie de la couche de germination 18 ;
des fils 24 (trois fils étant représentés) de hauteur H₁, chaque fil 24 étant en contact avec la couche de germination 18, chaque fil 24 comprenant une portion inférieure 26, de hauteur H₂, en contact avec la couche de germination 18 et une portion supérieure 28, de hauteur H₃, prolongeant la portion inférieure 26 ;
une coque 30 comprenant un empilement de couches semiconductrices recouvrant chaque portion supérieure 28 ;
une portion isolante 32 s'étendant sur la couche 22 entre les fils 24 sur la hauteur H₂ ;
une couche de seconde électrode 34 recouvrant chaque coque 30 et s'étendant sur la portion isolante 32 ; et
une couche d'encapsulation 36 recouvrant la couche de seconde électrode 34.

La coque 30 comprend notamment une couche active qui est la couche depuis laquelle est émise la majorité du rayonnement électromagnétique fourni par le dispositif 10. L'ensemble formé par chaque fil 24 et la coque 30 associée constitue une structure de diode électroluminescente DEL.

De la lumière est émise par chaque diode électroluminescente DEL dans toutes les directions depuis la coque 30. Seule la lumière qui s'échappe du dispositif optoélectronique 10 en traversant la couche d'encapsulation 36 est vue par un observateur. Toutefois, une partie de la lumière émise par les diodes électroluminescentes DEL est capturée dans les fils 24 et dans le substrat 14 et n'est donc pas perçue par un observateur. On appelle réflectivité du dispositif optoélectronique 10 le rapport entre la quantité de lumière qui s'échappe de la couche d'encapsulation 36 et la quantité de lumière émise par les diodes électroluminescentes DEL. Il est souhaitable que la réflectivité soit la plus élevée possible.

Ainsi, un objet d'un mode de réalisation est de pallier au moins en partie les inconvénients des dispositifs optoélectroniques à diodes électroluminescentes, notamment à microfils ou nanofils, et de leurs procédés de fabrication décrits précédemment.

Un autre objet d'un mode de réalisation est d'augmenter la réflectivité du dispositif optoélectronique à diodes électroluminescentes.

Un autre objet d'un mode de réalisation est que les diodes électroluminescentes en matériau semiconducteur puissent être formées à une échelle industrielle et à bas coût.

La figure 2 est une coupe, partielle et schématique, d'un mode de réalisation d'un dispositif optoélectronique 40, selon la présente invention, réalisé à partir de fils tel que décrit précédemment et adapté à l'émission d'un rayonnement électromagnétique.

Le dispositif optoélectronique 40 comprend l'ensemble des éléments du dispositif optoélectronique 10 décrit précédemment en relation avec la figure 1 et comprend, en outre, une couche 42, appelée par la suite couche miroir, située sous la couche de germination 18 et adaptée à augmenter la réflectivité du dispositif 40. Le dispositif optoélectronique 40 peut, en outre, comprendre une couche de protection 44 interposée entre le substrat 14 et la couche miroir 42.

Selon le présent mode de réalisation, les matériaux composant la couche de germination 18 et la couche miroir 42 et les épaisseurs de la couche de germination 18 et de la couche miroir 42 sont sélectionnés pour augmenter la réflectivité du dispositif optoélectronique 40.

L'indice optique complexe, également appelé indice de réfraction complexe, est un nombre sans dimension qui caractérise les propriétés optiques d'un milieu, notamment l'absorption et la diffusion.

L'indice de réfraction est égal à la partie réelle de l'indice optique complexe. Le coefficient d'extinction, également appelé coefficient d'atténuation, d'un matériau, mesure la perte d'énergie d'un rayonnement électromagnétique traversant ce matériau. Le coefficient d'extinction est égal à l'opposé de la partie imaginaire de l'indice de réfraction complexe. L'indice de réfraction et le coefficient d'extinction d'un matériau peuvent être déterminés, par exemple, par ellipsométrie. Une méthode d'analyse des données ellipso-métriques est décrite dans l'ouvrage intitulé "Spectroscopic ellipsometry, Principles and Applications" de Hiroyuki Fujiwara, édité par John Wiley & Sons, Ltd (2007).

De préférence, le matériau composant la couche miroir 42 est électriquement conducteur.

Selon la présente invention, l'épaisseur de la couche miroir 42, notée eₘᵢᵣₒᵢᵣ, est supérieure ou égale à 15 nm.

Selon un mode de réalisation, l'indice de réfraction de la couche miroir 42, noté nₘᵢᵣₒᵢᵣ, est inférieur ou égal à 2 pour une longueur d'onde comprise entre 380 nm et 650 nm.

Selon la présente invention, le coefficient d'extinction de la couche miroir 42, noté kₘᵢᵣₒᵢᵣ est supérieur ou égal à 3 pour toute longueur d'onde comprise entre 380 nm et 650 nm.

A titre d'exemple, le matériau composant la couche miroir 42 peut être le chrome, le rhodium, le ruthénium, le palladium ou un alliage de deux de ces composés ou de plus de deux de ces composés.

Selon la présente invention, l'épaisseur de la couche de germination, notée e_{CN}, est inférieure ou égale à 20 nm.

Selon la présente invention, l'indice de réfraction de la couche de germination 18, noté n_{CN}, est compris entre 1 et 3 pour une longueur d'onde comprise entre 380 nm et 650 nm.

Selon la présente invention, le coefficient d'extinction de la couche de germination 18, noté k_{CN} est inférieur ou égal à 1,5 pour toute longueur d'onde comprise entre 380 nm et 650 nm.

Selon la présente invention, le matériau composant la couche de germination 18 est choisi parmi le groupe comprenant un nitrure, un carbure ou un borure d'un métal de transition de la colonne IV, V ou VI du tableau périodique des éléments ou une combinaison de ces composés, ou est spécifiquement choisi parmi le groupe comprenant le nitrure d'aluminium (AlN), le bore (B), le nitrure de bore (BN), le titane (Ti), le nitrure de titane (TiN), le tantale (Ta), le nitrure de tantale (TaN), l'hafnium (Hf), le nitrure d'hafnium (HfN), le niobium (Nb), le nitrure de niobium (NbN), le zirconium (Zr), le borate de zirconium (ZrB₂), le nitrure de zirconium (ZrN), le carbure de silicium (SiC), le nitrure et carbure de tantale (TaCN), le nitrure de magnésium sous la forme MgₓN_{y}, où x est environ égal à 3 et y est environ égal à 2, par exemple le nitrure de magnésium selon la forme Mg₃N₂ ou le nitrure de gallium et de magnésium (MgGaN), le tungstène (W), le nitrure de tungstène (WN) ou une combinaison de ceux-ci.

La couche de protection 44, éventuellement présente, permet d'éviter une modification du matériau constituant la couche miroir 42 par le matériau constituant le substrat 14, notamment au cours des étapes de fabrication des fils 24. A titre d'exemple, lorsque le substrat 14 est en silicium et que les fils 24 sont en GaN, la couche de protection 44 permet d'éviter la siliciuration du matériau constituant la couche miroir 42 lors des étapes de croissance des fils 24 qui peuvent comprendre des étapes réalisées à des températures de l'ordre de 1000°C.

Selon un mode de réalisation, l'épaisseur de la couche de protection 44 est comprise entre 1 nm et 50 nm. La couche de protection 44 peut être réalisée avec les mêmes matériaux que la couche de germination 18.

Le substrat 14 est, par exemple, un substrat semiconducteur, tel qu'un substrat en silicium. Le substrat 14 est dopé d'un premier type de conductivité, par exemple dopé de type N. Les faces 15 et 16 peuvent être planes et parallèles. La face 16 du substrat 14 peut être une face <100>. La couche de germination 18 peut être dopée du même type de conductivité que le substrat ou du type de conductivité opposé.

L'électrode 12 peut correspondre à une couche conductrice qui s'étend sur la face 15 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

La couche isolante 22 et la portion isolante 32 peuvent être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant. A titre d'exemple, l'épaisseur de la couche isolante 22 est comprise entre 5 nm et 500 nm, par exemple égale à environ 30 nm.

Chaque fil 24 peut avoir une structure semiconductrice allongée selon un axe D sensiblement perpendiculaire à la face 16. Chaque fil 24 peut avoir une forme générale cylindrique allongée à base hexagonale. Le diamètre moyen de chaque fil 24 peut être compris entre 50 nm et 2,5 µm et la hauteur H₁ de chaque fil 24 peut être comprise entre 250 nm et 50 µm.

Les axes de deux fils 24 adjacents peuvent être distants de 0,5 µm à 10 µm et de préférence de 1,5 µm à 4 µm. A titre d'exemple, les fils 24 peuvent être régulièrement répartis. A titre d'exemple, les fils 24 peuvent être répartis selon un réseau hexagonal.

A titre d'exemple, la portion inférieure 26 de chaque fil 24 est principalement constituée du composé III-N, par exemple du nitrure de gallium, dopé du premier type de conductivité, par exemple au silicium. Le pourtour de la portion inférieure 26 peut être recouvert d'une couche diélectrique, par exemple du SiN, sur la hauteur H₂ depuis l'extrémité de la portion inférieure 26 au contact avec la couche de germination 18. La hauteur H₂ peut être comprise entre 100 nm et 25 µm. Cette couche diélectrique peut avoir une épaisseur comprise entre une monocouche atomique et 100 nm, de préférence entre une monocouche atomique et 10 nm.

La portion supérieure 28 de chaque fil 24 est, par exemple, au moins partiellement réalisée dans un composé III-N, par exemple du GaN. La portion supérieure 28 peut être dopée du premier type de conductivité, ou ne pas être intentionnellement dopée. La portion supérieure 28 s'étend sur la hauteur H₃ qui peut être comprise entre 100 nm et 25 µm.

Dans le cas d'un fil composé principalement de GaN, la structure cristalline du fil peut être du type wurtzite, le fil s'étendant selon l'axe C. La structure cristalline du fil peut également être du type cubique.

La coque 30 peut comprendre un empilement d'une couche active recouvrant la portion supérieure 28 du fil 24 associé et d'une couche de liaison entre la couche active et l'électrode 34.

La couche active est la couche depuis laquelle est émise la majorité du rayonnement fourni par le dispositif 40. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche de liaison peut correspondre à une couche semiconductrice ou à l'empilement de couches semiconductrices et permet la formation d'une jonction P-N ou P-I-N avec la couche active et/ou la portion supérieure 28. Elle permet l'injection de trous dans la couche active via l'électrode 34. L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et une couche supplémentaire, pour assurer un bon contact électrique entre la deuxième électrode 34 et la couche active, par exemple en nitrure de gallium (GaN) en contact avec la couche de blocage d'électrons et avec l'électrode 34. La couche de liaison peut être dopée du type de conductivité opposé à celui de la portion 28, par exemple dopée de type P.

La deuxième électrode 34 est adaptée à polariser la couche active de chaque fil 24 et laisser passer le rayonnement électromagnétique émis par les fils 24. Le matériau formant l'électrode 34 peut être un matériau transparent et conducteur tel que de l'oxyde d'indium-étain (ou ITO, acronyme anglais pour Indium Tin Oxide), de l'oxyde de zinc dopé à l'aluminium ou du graphène.

La couche d'encapsulation 36 peut être en silice (SiO₂).

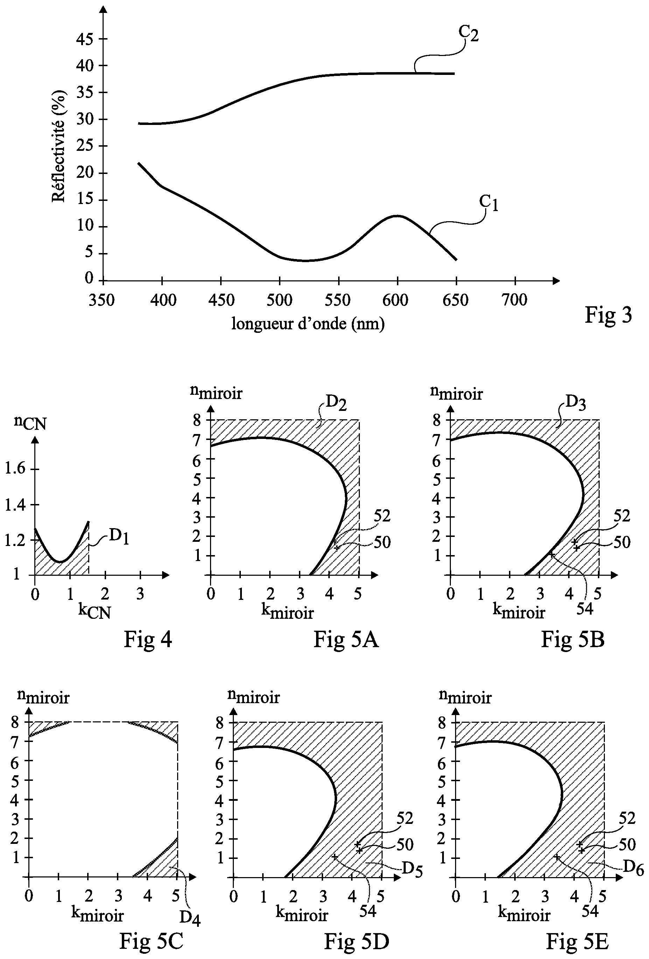

La figure 3 représente des courbes d'évolution C₁ et C₂ respectivement de la réflectivité du dispositif optoélectronique 10 représenté en figure 1 et du dispositif optoélectronique 40 représenté en figure 2, mesurée sous un fil 24. Les courbes C₁ et C₂ ont été déterminées par simulation en considérant un empilement comprenant le substrat 14 en silicium, la couche de germination 18 en ZrN avec une épaisseur de 10 nm et un fil 24 en GaN. Pour la courbe C₁, la couche miroir 42 n'est pas présente et pour la courbe C₂, l'empilement comprend en outre la couche miroir 42 en chrome et avec une épaisseur de 40 nm. Lorsque la couche miroir 42 est présente, il a été obtenu une augmentation d'au moins 30 % de la réflectivité pour une longueur d'onde comprise entre 380 nm et 650 nm. De façon avantageuse, la courbe C₂ croît de façon monotone pour une longueur d'onde comprise entre 380 nm et 650 nm. La réflectivité augmente donc avec la longueur d'onde. Ceci est avantageux dans la mesure où l'efficacité d'émission de lumière du dispositif optoélectronique peut diminuer avec la longueur d'onde. L'augmentation de la réflectivité avec la longueur d'onde permet donc de compenser au moins partiellement la diminution de l'efficacité d'émission de lumière avec la longueur d'onde.

On a représenté par une zone hachurée en figure 4 le domaine D₁ des indices de réfraction n_{CN}, en ordonnée, et des coefficients d'extinction k_{CN}, en abscisse, de la couche de germination 18 pour lesquels la réflectivité sous fil est supérieure à 30 % pour une longueur d'onde comprise 380 nm et 650 nm lorsque la couche miroir 42 n'est pas présente. Le domaine D₁ a été déterminé par simulation avec une couche de germination 18 ayant une épaisseur e_{CN} de 10 nm. Comme cela apparaît, le domaine D₁ est réduit, ce qui signifie que, en l'absence de la couche miroir 42, le choix des matériaux pour la réalisation de la couche de germination 18 permettant l'obtention d'une réflectivité sous fil supérieure à 30 % pour une longueur d'onde comprise 380 nm et 650 nm est restreint.

On a représenté par des zones hachurées aux figures 5A à 5E respectivement les domaines D₂, D₃, D₄, D₅ et D₆ des indices de réfraction nₘᵢᵣₒᵢᵣ, en ordonnée, et des coefficients d'extinction kₘᵢᵣₒᵢᵣ, en abscisse, de la couche miroir 42 pour lesquels une réflectivité sous fil supérieure à 40 % pour une longueur d'onde comprise entre 380 nm et 650 nm est obtenue. Les domaines D₂ à D₆ ont été déterminés par simulation pour différents indices de réfraction n_{CN} et différents coefficients d'extinction k_{CN} de la couche de germination 18. Les domaines D₂ à D₆ ont été déterminés avec une couche de germination 18 ayant une épaisseur e_{CN} de 10 nm.

Le domaine D₂ représenté en figure 5A a été déterminé avec une couche de germination 18 ayant un indice de réfraction n_{CN} égal à 2 et un coefficient d'extinction k_{CN} égal à 1,5. Le domaine D₃ représenté en figure 5B a été déterminé avec une couche de germination 18 ayant un indice de réfraction n_{CN} égal à 2 et un coefficient d'extinction k_{CN} égal à 0,5. Le domaine D₄ représenté en figure 5C a été déterminé avec une couche de germination 18 ayant un indice de réfraction n_{CN} égal à 3 et un coefficient d'extinction k_{CN} égal à 0,5. Le domaine D₅ représenté en figure 5D a été déterminé avec une couche de germination 18 ayant un indice de réfraction n_{CN} égal à 1 et un coefficient d'extinction k_{CN} égal à 1,5. Le domaine D₆ représenté en figure 5E a été déterminé avec une couche de germination 18 ayant un indice de réfraction n_{CN} égal à 2 et un coefficient d'extinction k_{CN} égal à 0,5.

Les inventeurs ont sélectionnés les matériaux à fort coefficients d'extinction qui appartiennent aux domaines D₂ à D₆ des indices de réfraction nₘᵢᵣₒᵢᵣ et des coefficients d'extinction kₘᵢᵣₒᵢᵣ de la couche miroir 42 pour lesquels une réflectivité sous fil supérieure à 40 % pour une longueur d'onde comprise entre 380 nm et 650 nm est obtenue. Il s'agit de métaux ou d'alliages métalliques qui ont un indice de réfraction inférieur ou égal à 2 et un coefficient d'extinction supérieur ou égal 3. A titre d'exemple, sur les figures 5A, 5B, 5D et 5E, la croix 50 représente le rhodium, la croix 52 représente le chrome et la croix 54 représente le palladium.

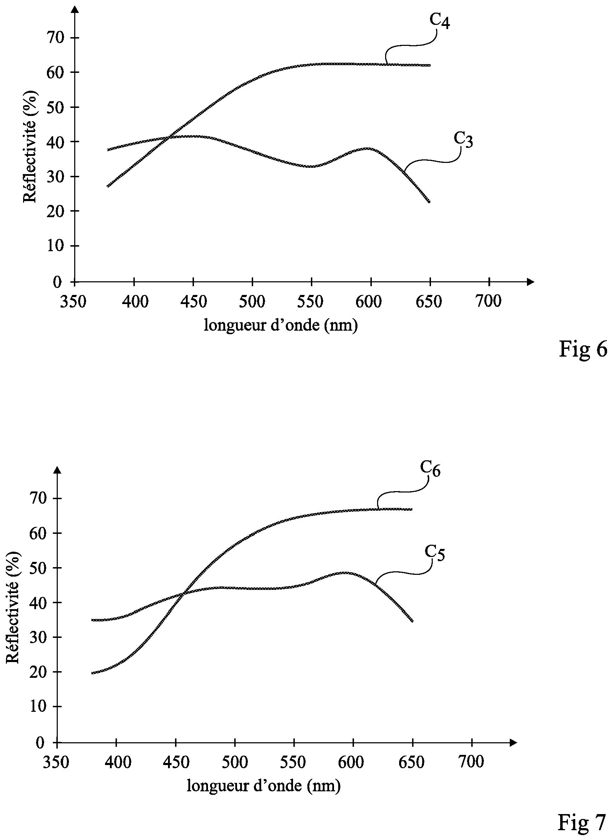

La figure 6 représente des courbes d'évolution C₃ et C₄ respectivement de la réflectivité du dispositif optoélectronique 10 représenté en figure 1 et du dispositif optoélectronique 40 représenté en figure 2, mesurée entre deux fils 24 adjacents. Les courbes C₃ et C₄ ont été déterminées par simulation en considérant un empilement comprenant le substrat 14 en silicium, la couche de germination 18 en ZrN avec une épaisseur de 10 nm, la couche diélectrique 22 et la portion isolante 32 en SiO₂ avec une épaisseur totale de 80 nm, la couche d'électrode 34 en ITO avec une épaisseur de 80 nm et la couche d'encapsulation 36 en SiO₂ avec une épaisseur de 10 µm. Pour la courbe C₃, la couche miroir 42 n'est pas présente et pour la courbe C₄, l'empilement comprend en outre la couche miroir 42 en chrome avec une épaisseur de 40 nm. En présence de la couche miroir 42, il a été obtenu une augmentation en moyenne d'au moins 40 % de la réflectivité pour une longueur d'onde comprise entre 380 nm et 650 nm. De façon avantageuse, la courbe C₄ croît de façon monotone pour une longueur d'onde comprise entre 380 nm et 650 nm. La réflectivité augmente donc avec la longueur d'onde.

La figure 7 représente des courbes d'évolution C₅ et C₆ respectivement de la réflectivité du dispositif optoélectronique 10 représenté en figure 1 et du dispositif optoélectronique 40 représenté en figure 2 mesurée entre deux fils 24 adjacents. Par rapport aux courbes C₃ et C₄, les courbes C₅ et C₆ ont été déterminées par simulation en considérant que la couche diélectrique 22 et la portion isolante 32 ont une épaisseur totale de 40 nm et que la couche d'électrode 34 a une épaisseur de 90 nm. Ces épaisseurs ont été déterminées pour obtenir la réflectivité maximale à la longueur d'onde de 650 nm. En présence de la couche miroir 42, il a été obtenu une augmentation en moyenne d'au moins 18 % de la réflectivité pour une longueur d'onde comprise entre 380 nm et 650 nm. De façon avantageuse, la courbe C₆ croît de façon monotone pour une longueur d'onde comprise entre 380 nm et 650 nm. La réflectivité augmente donc avec la longueur d'onde.

En outre, les figures 6 et 7 illustrent le fait que l'allure générale de la courbe d'évolution de la réflectivité, notamment l'augmentation de la réflectivité avec la longueur d'onde, est obtenue indépendamment des épaisseurs des couches du dispositif optoélectronique.

Un mode de réalisation du procédé de fabrication du dispositif optoélectronique 40 comprend les étapes suivantes :
(1) Dépôt successif sur le substrat 14 de la couche de protection 44, de la couche miroir 42 et de la couche de germination 18. La couche de protection 44 peut ne pas être présente. La couche miroir 42 peut être obtenue par un procédé du type CVD ou dépôt physique en phase vapeur (PVD, sigle anglais pour Physical Vapor Déposition).
   La couche de germination 18, et éventuellement la couche de protection 44, peuvent être obtenues par un procédé du type MOCVD. Toutefois, des procédés tels que CVD, MBE, GSMBE, MOMBE, ALE, HVPE, ALD (acronyme anglais pour Atomic Layer Déposition), l'évaporation ou la pulvérisation cathodique réactive peuvent être utilisés ou tout type de dépôt permettant l'obtention d'une couche texturée. Lorsque la couche de germination 18 est en nitrure d'aluminium, elle peut être sensiblement texturée et posséder une polarité préférentielle. La texturation de la couche 18 peut être obtenue par un traitement supplémentaire réalisé après le dépôt de la couche de germination 18. Il s'agit, par exemple, d'un recuit sous flux d'ammoniac (NH₃).
(2) Dépôt de la couche 22 d'un matériau diélectrique sur la couche de germination 18. La couche 22 est en un matériau diélectrique qui peut être gravé de façon sélective par rapport au matériau formant la couche de germination 18. Le matériau diélectrique est, par exemple, du nitrure de silicium (par exemple Si₃N₄) ou de l'oxyde de silicium (SiO₂).
(3) Gravure des ouvertures 23 dans la couche diélectrique 22 pour exposer des zones de la couche de germination 18. La gravure des ouvertures 23 peut être réalisée par une étape de gravure sélective qui n'entraîne pas de gravure de la couche de germination 18. Il peut s'agir d'une gravure ionique ou d'une gravure par ions réactifs.
(4) Croissance de la portion passivée 26 de chaque fil 24 sur la hauteur H₂. Chaque fil 24 croît depuis la couche de germination 18. La portion inférieure 26 de chaque fil 24 peut être obtenue par un procédé du type MOCVD. Toutefois, des procédés tels que CVD, MBE, GSMBE, MOMBE, PAMBE, ALE, HVPE, ou électro-chimiques peuvent être utilisés.
   A titre d'exemple, dans le cas où la portion inférieure 26 est en GaN fortement dopé de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.
   La présence de silane parmi les gaz précurseurs entraîne l'incorporation de silicium au sein du composé GaN. On obtient ainsi une portion inférieure 26 dopée de type N. En outre, ceci se traduit par la formation d'une couche de nitrure de silicium qui recouvre le pourtour de la portion 26 de hauteur H₂, à l'exception du sommet au fur et à mesure de la croissance de la portion 26.
(5) Croissance de la portion supérieure 28 de hauteur H₃ de chaque fil 24 sur le sommet de la portion inférieure 26. Pour la croissance de la portion supérieure 28, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 28 peut être dopée de type N en raison de la diffusion dans cette portion active de dopants provenant des portions passivées adjacentes ou en raison du dopage résiduel du GaN.
(6) Formation par épitaxie, pour chaque fil 24, des couches composant la coque 30. Compte tenu de la présence de la portion passivante recouvrant le pourtour de la portion inférieure 26, le dépôt des couches composant la coque 30 ne se produit que sur la portion supérieure 28 du fil 24 ;
(7) Formation de la portion isolante 32, par exemple par le dépôt conforme d'une couche isolante et la gravure de cette couche isolante pour exposer les coques 30 des fils 24 ; et
(8) Formation des électrodes 34 et 12.

Des modes de réalisation particuliers de la présente invention ont été décrits. Diverses variantes et modifications apparaîtront à l'homme de l'art dans le cadre des revendications de la présente invention.

En particulier, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est clair que la deuxième électrode peut être prévue du côté de la première face.

De plus, bien que, dans les modes de réalisation décrits précédemment, chaque fil 24 comprenne une portion passivée 26, à la base du fil en contact avec la couche de germination 18, cette portion passivée 26 peut ne pas être présente.

En outre, bien que des modes de réalisation aient été décrits pour un dispositif optoélectronique comprenant une couche miroir 42 recouvrant la totalité du substrat 14, il est clair que la couche miroir 42 peut être remplacée par des portions, du même matériau que la couche miroir 42, prévues au moins sous chaque fil 24 et/ou prévues entre des fils 24 adjacents.

De plus, bien que des modes de réalisation aient été décrits pour un dispositif optoélectronique comprenant une couche de germination 18 recouvrant la totalité de la couche miroir 42, il est clair que la couche de germination 18 peut être remplacée par des îlots de germination prévus sous chaque fil 24.

En outre, bien que des modes de réalisation aient été décrits pour un dispositif optoélectronique pour lequel la coque 30 recouvre le sommet du fil 24 associé et une partie des flancs latéraux du fil 24, la coque peut n'être prévue qu'au sommet du fil 24.

L'objet de la protection conférée par la présente invention est défini par les revendications qui suivent.

## Revendications

1. Dispositif optoélectronique (40) comprenant :
un substrat (14) ;
une première couche (42) ou des premières portions recouvrant le substrat (14), la première couche (42) ou les premières portions ayant une épaisseur supérieure ou égale à 15 nm et comprenant un premier matériau ayant un coefficient d'extinction supérieur ou égal à 3 pour toute longueur d'onde comprise entre 380 nm et 650 nm ;
une deuxième couche (18) ou des deuxièmes portions recouvrant la première couche (42) ou les premières portions et au contact de la première couche ou des premières portions, la deuxième couche (18) ou les deuxièmes portions ayant une épaisseur inférieure ou égale à 20 nm et comprenant un deuxième matériau ayant un indice de réfraction compris entre 1 et 3 et un coefficient d'extinction inférieur ou égal à 1,5 pour toute longueur d'onde comprise entre 380 nm et 650 nm ; et
des ensembles (24, 30) à structure de diodes électroluminescentes (DEL) comprenant des éléments semiconducteurs (24) filaires, coniques ou tronconiques, les éléments semiconducteurs (24) étant au contact de la deuxième couche ou des deuxièmes portions, la première couche (42) ou les premières portions étant interposée(s) entre le substrat (14) et les éléments semiconducteurs (24),
dans lequel le deuxième matériau est choisi parmi le groupe comprenant un nitrure, un carbure ou un borure d'un métal de transition de la colonne IV, V ou VI du tableau périodique des éléments ou une combinaison de ces composés, ou est spécifiquement choisi parmi le groupe comprenant le nitrure d'aluminium (AlN), le bore (B), le nitrure de bore (BN), le titane (Ti), le nitrure de titane (TiN), le tantale (Ta), le nitrure de tantale (TaN), l'hafnium (Hf), le nitrure d'hafnium (HfN), le niobium (Nb), le nitrure de niobium (NbN), le zirconium (Zr), le borate de zirconium (ZrB₂), le nitrure de zirconium (ZrN), le carbure de silicium (SiC), le nitrure et carbure de tantale (TaCN), le nitrure de magnésium sous la forme MgₓN_{y}, où x est environ égal à 3 et y est environ égal à 2, par exemple le nitrure de magnésium selon la forme Mg₃N₂ ou le nitrure de gallium et de magnésium (MgGaN), le tungstène (W), le nitrure de tungstène (WN) ou une combinaison de ces composés.

2. Dispositif optoélectronique selon la revendication 1, dans lequel le premier matériau est choisi parmi le groupe comprenant le chrome, le rhodium, le ruthénium, le palladium ou un alliage de deux de ces composés ou de plus de deux de ces composés.

3. Dispositif optoélectronique selon la revendication 1 ou 2, dans lequel chaque élément semiconducteur (24) comprend un microfil ou un nanofil.

4. Dispositif optoélectronique selon l'une quelconque des revendications 1 à 3, dans lequel le substrat (14) est en un troisième matériau semiconducteur choisi parmi le groupe comprenant le silicium, le germanium, le carbure de silicium, un composé III-V, un composé II-VI et une combinaison de ces composés.

5. Dispositif optoélectronique selon l'une quelconque des revendications 1 à 4, dans lequel chaque élément semiconducteur (24) comprend au moins une partie (26) comprenant majoritairement un quatrième matériau semiconducteur en contact avec la deuxième couche (18) ou l'une des deuxièmes portions, le quatrième matériau semiconducteur étant choisi parmi le groupe comprenant le silicium, le germanium, le carbure de silicium, un composé III-V, un composé II-VI et une combinaison de ces composés.

6. Dispositif optoélectronique selon l'une quelconque des revendications 1 à 5, dans lequel chaque élément semiconducteur (24) est au moins partiellement recouvert d'une structure (30) semiconductrice adaptée à émettre de la lumière.

7. Dispositif optoélectronique selon l'une quelconque des revendications 1 à 6, comprenant, en outre, une troisième couche (44) entre la première couche (42) ou les premières portions et le substrat (14).

8. Dispositif optoélectronique selon la revendication 7, dans lequel la troisième couche (44) et la deuxième couche (18) ou les deuxièmes portions sont du même matériau.

9. Procédé de fabrication d'un dispositif optoélectronique (40) comprenant les étapes suivantes :
former, sur un substrat (14), une première couche (42) ou des premières portions, la première couche (42) ou les premières portions ayant une épaisseur supérieure ou égale à 15 nm et comprenant un premier matériau ayant un coefficient d'extinction supérieur ou égal à 3 pour toute longueur d'onde comprise entre 380 nm et 650 nm ;
former une deuxième couche (18) ou des deuxièmes portions recouvrant la première couche (42) ou les premières portions et au contact de la première couche ou des premières portions, la deuxième couche (18) ou les deuxièmes portions ayant une épaisseur inférieure ou égale à 20 nm et comprenant un deuxième matériau ayant un indice de réfraction compris entre 1 et 3 et un coefficient d'extinction inférieur ou égal à 1,5 pour toute longueur d'onde comprise entre 380 nm et 650 nm ; et
former des ensembles (24, 30) à structure de diodes électroluminescentes (DEL) comprenant des éléments semiconducteurs (24) filaires, coniques ou tronconiques au contact de la deuxième couche ou des deuxièmes portions, la première couche (42) ou les premières portions étant interposée(s) entre le substrat (14) et les éléments semiconducteurs (24),
dans lequel le deuxième matériau est choisi parmi le groupe comprenant un nitrure, un carbure ou un borure d'un métal de transition de la colonne IV, V ou VI du tableau périodique des éléments ou une combinaison de ces composés, ou est spécifiquement choisi parmi le groupe comprenant le nitrure d'aluminium (AlN), le bore (B), le nitrure de bore (BN), le titane (Ti), le nitrure de titane (TiN), le tantale (Ta), le nitrure de tantale (TaN), l'hafnium (Hf), le nitrure d'hafnium (HfN), le niobium (Nb), le nitrure de niobium (NbN), le zirconium (Zr), le borate de zirconium (ZrB₂), le nitrure de zirconium (ZrN), le carbure de silicium (SiC), le nitrure et carbure de tantale (TaCN), le nitrure de magnésium sous la forme MgₓN_{y}, où x est environ égal à 3 et y est environ égal à 2, par exemple le nitrure de magnésium selon la forme Mg₃N₂ ou le nitrure de gallium et de magnésium (MgGaN), le tungstène (W), le nitrure de tungstène (WN) ou une combinaison de ces composés.

## Patentansprüche

1. Eine optoelektronische Vorrichtung (40), die Folgendes aufweist:
ein Substrat (14);
eine erste Schicht (42) oder erste Teile, die das Substrat (14) abdecken, wobei die erste Schicht (42) oder die ersten Teile eine Dicke von größer oder gleich 15 nm haben und ein erstes Material mit einem Extinktionskoeffizienten von größer oder gleich 3 für jede Wellenlänge im Bereich von 380 nm bis 650 nm haben;
eine zweite Schicht (18) oder zweite Teile, die die erste Schicht (42) oder die ersten Teile abdecken und in Kontakt mit der ersten Schicht oder mit den ersten Teilen sind, wobei die zweite Schicht (18) oder die zweiten Teile eine Dicke kleiner oder gleich 20 nm haben und ein zweites Material mit einem Brechungsindex im Bereich von 1 bis 3 und einem Extinktionskoeffizienten kleiner oder gleich 1,5 für jede Wellenlänge im Bereich von 380 nm bis 650 nm haben; und
Anordnungen (24, 30) mit einer Struktur aus lichtemittierenden Dioden (LED), die drahtförmige, konische oder kegelstumpfförmige Halbleiterelemente (24) aufweisen, wobei die Halbleiterelemente (24) mit der zweiten Schicht oder mit den zweiten Teilen in Kontakt sind, wobei die erste Schicht (42) oder die ersten Teile zwischen dem Substrat (14) und den Halbleiterelementen (24) angeordnet sind,
wobei das zweite Material aus der Gruppe ausgewählt ist, die Folgendes aufweist: ein Nitrid, ein Carbid oder ein Borid eines Übergangsmetalls der Spalte IV, V oder VI des Periodensystems der Elemente oder eine Kombination dieser Verbindungen, oder spezifisch aus der Gruppe ausgewählt ist, die Folgendes aufweist: Aluminiumnitrid (AlN), Bor (B), Bornitrid (BN), Titan (Ti), Titannitrid (TiN), Tantal (Ta), Tantalnitrid (TaN), Hafnium (Hf), Hafniumnitrid (HfN), Niob (Nb), Niobnitrid (NbN), Zirkonium (Zr), Zirkoniumborat (ZrB₂), Zirkoniumnitrid (ZrN), Siliciumcarbid (SiC), Tantalcarbonitrid (TaCN), Magnesiumnitrid in MgₓN_{y}-Form, wobei x ungefähr gleich 3 und y ungefähr gleich 2 ist, z.B. Magnesiumnitrid in Mg₃N₂-Form oder Magnesium-Gallium-Nitrid (MgGaN), Wolfram (W), Wolframnitrid (WN) oder eine Kombination dieser Verbindungen.

2. Optoelektronische Vorrichtung nach Anspruch 1, wobei das erste Material aus der Gruppe ausgewählt ist, die Chrom, Rhodium, Ruthenium, Palladium oder eine Legierung aus zwei dieser Verbindungen oder aus größer zwei dieser Verbindungen aufweist.

3. Optoelektronische Vorrichtung nach Anspruch 1 oder 2, wobei jedes Halbleiterelement (24) einen Mikrodraht oder einen Nanodraht aufweist.

4. Optoelektronische Vorrichtung nach einem der Ansprüche 1 bis 3, wobei das Substrat (14) aus einem dritten Halbleitermaterial hergestellt ist, das aus der Gruppe ausgewählt ist, die Silizium, Germanium, Siliziumkarbid, eine III-V-Verbindung, eine II-VI-Verbindung und eine Kombination dieser Verbindungen aufweist.

5. Optoelektronische Vorrichtung nach einem der Ansprüche 1 bis 4, wobei jedes Halbleiterelement (24) wenigstens einen Teil (26) aufweist, der hauptsächlich ein viertes Halbleitermaterial in Kontakt mit der zweiten Schicht (18) oder einem der zweiten Teile aufweist, wobei das vierte Halbleitermaterial aus der Gruppe ausgewählt ist, die Silicium, Germanium, Siliciumcarbid, eine III-V-Verbindung, eine II-VI-Verbindung und eine Kombination dieser Verbindungen aufweist.

6. Optoelektronische Vorrichtung nach einem der Ansprüche 1 bis 5, wobei jedes Halbleiterelement (24) wenigstens teilweise mit einer Halbleiterstruktur (30) abgedeckt ist, die Licht emittieren kann.

7. Optoelektronische Vorrichtung nach einem der Ansprüche 1 bis 6, die ferner eine dritte Schicht (44) zwischen der ersten Schicht (42) oder den ersten Teilen und dem Substrat (14) aufweist.

8. Optoelektronische Vorrichtung nach Anspruch 7, wobei die dritte Schicht (44) und die zweite Schicht (18) oder die zweiten Teile aus dem gleichen Material hergestellt sind.

9. Verfahren zur Herstellung einer optoelektronischen Vorrichtung (40), das die folgenden Schritte aufweist:
Ausbilden einer ersten Schicht (42) oder erster Teile auf einem Substrat (14), wobei die erste Schicht (42) oder die ersten Teile eine Dicke von größer oder gleich 15 nm haben und ein erstes Material mit einem Extinktionskoeffizienten von größer oder gleich 3 für jede Wellenlänge im Bereich von 380 nm bis 650 nm haben;
Ausbilden einer zweiten Schicht (18) oder zweiter Teile, die die erste Schicht (42) oder die ersten Teile abdecken, wobei die zweite Schicht (18) oder die zweiten Teile eine Dicke von kleiner oder gleich 20 nm haben und ein zweites Material mit einem Brechungsindex im Bereich von 1 bis 3 und einem Extinktionskoeffizienten von kleiner oder gleich 1,5 für jede Wellenlänge im Bereich von 380 nm bis 650 nm haben; und
Ausbilden der Anordnungen (24, 30), die eine Struktur aus lichtemittierenden Dioden (LED) mit drahtförmigen, konischen oder kegelstumpfförmigen Halbleiterelementen (24) in Kontakt mit der zweiten Schicht oder mit den zweiten Teilen haben, wobei die erste Schicht (42) oder die ersten Teile zwischen dem Substrat (14) und den Halbleiterelementen (24) angeordnet sind,
wobei das zweite Material aus der Gruppe ausgewählt ist, die Folgendes aufweist: ein Nitrid, ein Carbid oder ein Borid eines Übergangsmetalls der Spalte IV, V oder VI des Periodensystems der Elemente oder eine Kombination dieser Verbindungen, oder spezifisch aus der Gruppe ausgewählt ist, die Folgendes aufweist: Aluminiumnitrid (AlN), Bor (B), Bornitrid (BN), Titan (Ti), Titannitrid (TiN), Tantal (Ta), Tantalnitrid (TaN), Hafnium (Hf), Hafniumnitrid (HfN), Niob (Nb), Niobnitrid (NbN), Zirkonium (Zr), Zirkoniumborat (ZrB₂), Zirkoniumnitrid (ZrN), Siliciumcarbid (SiC), Tantalcarbonitrid (TaCN), Magnesiumnitrid in MgₓN_{y}-Form, wobei x ungefähr gleich 3 und y ungefähr gleich 2 ist, z.B. Magnesiumnitrid in der Form von Mg₃N₂ oder Magnesiumgalliumnitrid (MgGaN), Wolfram (W), Wolframnitrid (WN) oder eine Kombination dieser Verbindungen.

## Claims

1. An optoelectronic device (40) comprising:
a substrate (14);
a first layer (42) or first portions covering the substrate (14), the first layer (42) or the first portions having a thickness greater than or equal to 15 nm and comprising a first material having an extinction coefficient greater than or equal to 3 for any wavelength in the range from 380 nm to 650 nm;
a second layer (18) or second portions covering the first layer (42) or the first portions and in contact with the first layer or with the first portions, the second layer (18) or the second portions having a thickness smaller than or equal to 20 nm and comprising a second material having a refraction index in the range from 1 to 3 and an extinction coefficient smaller than or equal to 1.5 for any wavelength in the range from 380 nm to 650 nm; and
assemblies (24, 30) having a structure of light-emitting diodes (LED) comprising wire, conical, or frustoconical semiconductor elements (24), the semiconductor elements (24) being in contact with the second layer or with the second portions, the first layer (42) or the first portions being interposed between the substrate (14) and the semiconductor elements (24),
wherein the second material is selected from the group comprising a nitride, a carbide, or a boride of a transition metal of column IV, V, or VI of the periodic table of elements or a combination of these compounds or is specifically selected from the group comprising aluminum nitride (AlN), boron (B), boron nitride (BN), titanium (Ti), titanium nitride (TiN), tantalum (Ta), tantalum nitride (TaN), hafnium (Hf), hafnium nitride (HfN), niobium (Nb), niobium nitride (NbN), zirconium (Zr), zirconium borate (ZrB₂), zirconium nitride (ZrN), silicon carbide (SiC), tantalum carbonitride (TaCN), magnesium nitride in MgₓN_{y} form, where x is approximately equal to 3 and y is approximately equal to 2, for example, magnesium nitride in Mg₃N₂ form or magnesium gallium nitride (MgGaN), tungsten (W), tungsten nitride (WN) or a combination of these compounds.

2. The optoelectronic device of claim 1, wherein the first material is selected from the group comprising chromium, rhodium, ruthenium, palladium, or an alloy of two of these compounds or of more than two of these compounds.

3. The optoelectronic device of claim 1 or 2, wherein each semiconductor element (24) comprises a microwire or a nanowire.

4. The optoelectronic device of any of claims 1 to 3, wherein the substrate (14) is made of a third semiconductor material selected from the group comprising silicon, germanium, silicon carbide, a III-V compound, a II-VI compound, and a combination of these compounds.

5. The optoelectronic device of any of claims 1 to 4, wherein each semiconductor element (24) comprises at least a portion (26) mainly comprising a fourth semiconductor material in contact with the second layer (18) or one of the second portions, the fourth semiconductor material being selected from the group comprising silicon, germanium, silicon carbide, a III-V compound, a II-VI compound, and a combination of these compounds.

6. The optoelectronic device of any of claims 1 to 5, wherein each semiconductor element (24) is at least partially covered with a semiconductor structure (30) capable of emitting light.

7. The optoelectronic device of any of claims 1 to 6, further comprising a third layer (44) between the first layer (42) or the first portions and the substrate (14).

8. The optoelectronic device of claim 7, wherein the third layer (44) and the second layer (18) or the second portions are made of the same material.

9. A method of manufacturing an optoelectronic device (40), comprising the steps of:
forming, on a substrate (14), a first layer (42) or first portions, the first layer (42) or the first portions having a thickness greater than or equal to 15 nm and comprising a first material having an extinction coefficient greater than or equal to 3 for any wavelength in the range from 380 nm to 650 nm;
forming a second layer (18) or second portions covering the first layer (42) or the first portions, the second layer (18) or the second portions having a thickness smaller than or equal to 20 nm and comprising a second material having a refraction index in the range from 1 to 3 and an extinction coefficient smaller than or equal to 1.5 for any wavelength in the range from 380 nm to 650 nm; and
forming assemblies (24, 30) having a structure of light-emitting diodes (LED) comprising wire, conical, or frustoconical semiconductor elements (24) in contact with the second layer or with the second portions, the first layer (42) or the first portions being interposed between the substrate (14) and the semiconductor elements (24),
wherein the second material is selected from the group comprising a nitride, a carbide, or a boride of a transition metal of column IV, V, or VI of the periodic table of elements or a combination of these compounds or is specifically selected from the group comprising aluminum nitride (AlN), boron (B), boron nitride (BN), titanium (Ti), titanium nitride (TiN), tantalum (Ta), tantalum nitride (TaN), hafnium (Hf), hafnium nitride (HfN), niobium (Nb), niobium nitride (NbN), zirconium (Zr), zirconium borate (ZrB₂), zirconium nitride (ZrN), silicon carbide (SiC), tantalum carbonitride (TaCN), magnesium nitride in MgₓN_{y} form, where x is approximately equal to 3 and y is approximately equal to 2, for example, magnesium nitride in Mg₃N₂ form or magnesium gallium nitride (MgGaN), tungsten (W), tungsten nitride (WN) or a combination of these compounds.
